Europäisches Patentamt

(19) European Patent Office

Office européen des brevets

(11) Publication number: **0 318 513 B1**

# EUROPEAN PATENT SPECIFICATION

(12)

(45) Date of publication of patent specification:
24.04.91 Bulletin 91/17

(51) Int. Cl.⁵: **C23C 2/04**

(21) Application number: 87905853.5

(22) Date of filing: 13.08.87

(86) International application number:
PCT/US87/02060

(87) International publication number:
WO 88/01309 25.02.88 Gazette 88/05

(54) **METHOD FOR FORMING A METAL COATING ON A SUBSTRATE.**

(30) Priority: 15.08.86 US 897116

(43) Date of publication of application:
07.06.89 Bulletin 89/23

(45) Publication of the grant of the patent:
24.04.91 Bulletin 91/17

(84) Designated Contracting States:
DE FR GB IT

(56) References cited:
US-A- 3 547 789

(73) Proprietor: MASSACHUSETTS INSTITUTE OF TECHNOLOGY
77 Massachusetts Avenue
Cambridge, MA 02139 (US)

(72) Inventor: SINGH, Rana, Partap
Westgate Apartment 508
Cambridge, MA 02139 (US)
Inventor: SADOWAY, Donald, R.
53 Vernon Road
Belmont, MA 02178 (US)

(74) Representative: Holdcroft, James Gerald, Dr. et al
Graham Watt & Co., Riverhead
Sevenoaks, Kent TN13 2BN (GB)

## Description

### METHOD FOR FORMING A METAL COATING ON A SUBSTRATE

### Background of the Invention

This invention is generally in the field of metal coatings and is in particular a method for creating a metal coating on electrically conductive and non-conductive substrates.

There are many instances in which it is desirable to form a metal coating on either a non-conductive substrate or a metal substrate. A number of methods have been used with a variety of materials for this purpose. One commonly used technique is electroplating. Others include chemical vapor deposition. Deposition technologies are reviewed in detail in Deposition Technologies for Films and Coatings by R. F. Bunshah et al. (Noyes Publications, Park Ridge, NJ 1982).

Electroplating is a process generally used to coat an object with a thin layer of a metal. The object to be plated is charged as the cathode and is immersed in an electrolyte bath which, among other things, contains a salt of the metal being plated. The anode can be made of the same metal or some chemically unaffected conductor. A low-voltage current is passed through the bath to electrolyze it and plate the cathode article with the metal to the desired thickness. A firm bond between the metal being deposited and the article is best obtained when using two metals that tend to alloy, such as silver and copper. Disadvantages to electroplating include stringent substrate requirements, such as the type of metal that can be plated, the necessity for absolute cleanliness, and difficulties in plating uneven surfaces. Other disadvantages include the necessity of uniform temperature control and replenishment of the electrolyte bath.

Chemical vapor deposition is frequently used to produce a very thin metal coating on a substrate, particularly a substrate formed of a non-conductive material such as silicon. In this method, the metal is vaporized using high temperatures (e.g. 800 to 900°C) and deposited onto the substrate. Unfortunately, at these high processing temperatures the metal coating diffuses into the underlying substrate at the same time as the deposit is forming. The result can be a diffuse rather than sharp interface between substrate and coating. Sharp interfaces improve device performance in most applications.

In general, many of the methods in use are limited to conductive metal substrates or substrates that can tolerate very high temperatures. Some of these methods may also be hazardous due to vaporization of toxic chemicals.

It is therefore an object of the present invention to provide a method for applying a thin metal coating to either an electrically conductive or non-conductive substrate.

It is a further object of the invention to provide a safe method for coating a substrate with a uniform metal layer which does not require the use of either an electrical current nor excessively high temperatures.

It is another object of the invention to provide a method for coating a substrate in such a way that there is little or no diffusion of the metal coating into the substrate.

It is still another object of the invention to provide a method for coating a substrate with multiple metal layers.

It is another object of the invention to provide a method for patterning a metal coating on a substrate.

It is yet another object of the invention to provide a method for purifying a metal, selectively doping a pure metal, and depositing an alloy at a specified ratio.

### Summary of the Invention

The preferred embodiment of the present invention is a method for producing a uniform metal coating on a substrate consisting of (1) selecting a metal to be coated onto the substrate, where the metal is soluble in a molten salt when heated, (2) preparing a bath by dissolving the metal in its molten salt, (3) immersing one or more substrates into the metal-molten salt bath and (4) decreasing the temperature of the bath at the substrate so that the metal will precipitate out onto the substrate.

The rate or extent of deposition using the dissolved method can be enhanced. For example, the rate of deposition is enhanced by the introduction of additional metal into the dissolved metal-molten salt bath by electrolysis, electrowinning or electrorefining. In a second example, precipitation of the metal is enhanced by addition of other salts to the metal-molten salt solution.

The method can also be used to deposit alloys of two or more metals onto a substrate, to purify the metal being deposited and to deposit a metal containing a specified concentration and composition of impurities. Bath composition and temperature are varied as required to promote deposition or to alter the stoichiometry of the metals and impurities. In general, the impurities will not be deposited at the same temperature and at the same concentrations as the metal to be purified. Since metal deposited under these conditions will not entrain molten salt, only the metal and the desired impurities, if any, are deposited.

When the method is used to deposit an alloy or an element along with a dopant, such as silicon along with boron, onto the substrate, the amount of dopant to be added to the bath in addition to the metal to be deposited is determined empirically from the ratio of dopant to silicon on the substrate at a particular temperature.

Multiple coatings can be formed, with the same or different metals by repeating the method, altering the bath composition and conditions as required.

The metal coating can be patterned by heating areas of the coating, in the metal-molten salt bath, to redissolve the metal or by masking areas to prevent deposition. For example, a metal, such as copper, is deposited onto a silica substrate. Patterns are "etched" into the copper layer by means of a laser which heats the substrate in a specified manner. At points heated by the laser, the metal goes back into solution in the molten salt, leaving a bare pattern on the substrate.

Detailed Description of the Invention

The present invention is a method for forming a metal coating on a substrate by exploiting the temperature dependence of metal solubility in a metal-molten salt solution. The metal to be deposited is first dissolved in the metal-molten salt solution, then precipitated out of the molten salt bath, onto a substrate by lowering the temperature of the bath at the place where it contacts the substrate. This can be accomplished by cooling the substrate, by cooling the bath or by cooling both the substrate and the bath. In reverse, a metal coating can be selectively removed by immersion of the coated substrate into a metal-molten salt bath and locally heating the areas at which the metal coating is to be removed.

It is a well-known fact that metals dissolve in their molten salts, as well as in mixtures containing their salts, without the passage of any current. Therefore, any metal that is soluble in a molten salt solution as a function of temperature can be used in the present invention. Examples of metal-molten salt solutions include Si in $K_2SiF_6$, in $MgCl_2$, and Cd in $CdCl_2$. The extent of dissolution and deposition are usually functions of the composition and temperature of the bath. Usually, the higher the concentration of the salt of the metal to be deposited and the higher the temperature of the bath, the greater the solubility of the metal.

Dissolution of the metal also occurs when current is passed through the bath during electroplating, electrowinning, or electrorefining. Such chemically dissolved metal can impart a measure of electronic conductivity to the electrolyte allowing it to pass current without electrodepositing metal. This reduces the current efficiency of electrolysis and is referred to as a departure from Faraday's Law.

The present invention is based on the observation that raising the temperature of the molten salt solution increases the solubility of the metal in the molten salt, and lowering the temperature lowers metal solubility. Since the molten salt solution at a lower temperature is supersaturated with the metal dissolved at a higher temperature, the metal tends to come out of solution. The subsequent introduction of a substrate into the supersaturated molten salt induces precipitation of the dissolved metal onto substrate. Since this involves the formation of critical size nuclei of the dissolved metal on the surface which grow to form a coating, the nature of the surface, i.e., crystal structure, roughness, temperature, etc., and the extent of saturation of the molten salt with the dissolved metal determine the nature and extent of the coating.

The extent of dissolution can be enhanced by increasing the salt concentration of the metal-molten salt solution. The solubility of a metal in a molten salt is at a maximum at any temperature when the melt consists of a pure salt of the given metal. Thus, it is possible to enhance metal rejection from a melt by adding other salts to change the bath composition after initial metal dissolution has occurred.

The method of the present invention can also be used to purify a metal, to alter the stoichiometric ratio of constituent elements in an alloy or compound, and to control the dopant concentration in a material such as silicon by exploiting the differential solubilities of various elements in molten salts.

To purify a metal, the metal is dissolved in the molten salt. At any temperature there is a solubility limit. Conversely, for any concentration of dissolved metal there is a temperature below which the metal precipitates out of solution. Through judicial choice of elemental concentrations and temperatures it is possible to precipitate the impurities out before the precipitation of the metal or to maintain them in solution while the metal is precipitated. A series of discrete precipitations may be performed or a thermal gradient formed in the metal-molten salt bath with a substrate introduced at the place where the optimum precipitation of a desired elemental constituent will occur.

In a similar fashion, an alloy can be deposited at a desired stoichiometric ratio after first determining the requisite concentrations of elements dissolved in the bath for deposition of the metal alloy or compound at the specified molar ratio. The kinetic processes associated with precipitation on a substrate surface make it possible to deposit alloys and compounds in stoichiometric ratios difficult to attain otherwise. For example, the higher volatility of the non-metal constituent in gallium arsenide and in mercury cadmium telluride results in non-stoichiometry when these compounds are processed from the vapor phase. The same method applies to a doped material such as silicon. A series of tests may be conducted on the metal-molten salt bath wherein the amount of metal or dopant deposited as a function of temperature and composition is determined. It is then relatively-straightforward for one skilled in the art to extrapolate backward to determine what temperature and what ratio of metal-molten salt bath components are required for the desired precipitate composition. In another embodiment of this invention, multiple coatings of the same or different composition are applied to the substrate by repeated processing in baths of the appropriate chemistry. A variety of coatings with respect to thickness and uniformity is also possible using variations in time of deposition, temperatures, bath compositions and addition to the bath of salt or metal through electrolysis.

In another embodiment of the method, the metal coating is continuously applied to one or more substrates by setting up a metal-molten salt bath and then forming and maintaining a thermal gradient such that at one end of the gradient metal is continuously dissolved into the metal-molten salt bath and precipitated out of solution onto the substrate at the other end of the gradient.

In a further embodiment of the method, a metal coating is applied to a substrate and then "patterned". The pattern is developed by heating selected portions of the metal coating on the substrate within the metal-molten salt bath. The heated metal dissolves back into the molten salt. Using a laser, the amount of material which is removed can be controlled and a very fine pattern etched into the metal. The metal coating can also be deposited in a pattern by masking the substrate in the areas not to be coated prior to placing the substrate in the metal-molten salt bath.

This invention is further illustrated by the following non-limiting examples demonstrating the deposition of a metal coating on both conductive and non-conductive substrates.

Example 1 : Formation of an Mn Coating on an Iron Substrate

A molten salt bath containing 50 mole percent $MnCl_2$-50 mole percent NaCl was prepared by melting the $MnCl_2$-NaCl in an iron crucible. A Mn rod was lowered into the crucible at 810°C. The temperature was increased to 900°C. After three hours, the Mn rod was pulled out of the salt. Approximately 20 grams NaCl was added to the melt to decrease Mn solubility and promote precipitation of the Mn from the molten salt solution. The temperature was lowered to 800°C and maintained at that temperature for two hours. The crucible was then cooled to room temperature.

An Mn coating was formed uniformly on the surface of the crucible, as determined by energy dispersive analysis by X-ray (EDAX).

Example 2 : Formation of an Mn Coating on a Copper Wire Substrate

A molten salt bath containing 20 mole percent $MnCl_2$-80 mole percent NaCl was prepared in a fused quartz crucible. As in Example 1, an Mn rod was lowered into the crucible, the crucible heated to 810°C, the temperature raised to 870°C for 20 minutes, and the rod removed. A copper wire, 1/8 th inch in diameter, was lowered into the salt bath. The salt bath was maintained at 744°C overnight.

The copper wire was then removed from the bath and analyzed by EDAX. Analysis confirmed a uniform deposition of Mn on the wire.

Example 3 : Formation of a Manganese Coating on a Fused Quartz Crucible

A 40 mole percent $MnCl_2$-60 mole percent NaCl bath was prepared using a procedure similar to those in Examples 1 and 2. A Mn rod was lowered into the salt bath, the temperature of the bath raised to approximately 900°C, the Mn rod withdrawn after 90 minutes and the bath cooled to room temperature. As before, additional NaCl was added to the bath after withdrawal of the Mn rod to decrease the solubility of the Mn in the molten salt.

A Mn coating was uniformly formed on the surface of the fused quartz crucible, as determined by EDAX. The coating had a very low electrical resistance, as measured using a digital multimeter. The uncoated side of the crucible had infinite resistance, indicating no deposition of the metallic coating.

Example 4 : Formation of a Molybdenum Coating on a Fused Quartz Surface by Chemical Deposition in the Presence of Electrodeposition

A bath containing $KCl$-$K_3MoCl_6$ (93 wt. percent KCl– wt. percent $K_3MoCl_6$) was heated to 800°C in a graphite crucible. Electrodeposition of Mo was conducted in the crucible using a Mo rod as the anode and a graphite rod as the cathode. A fused quartz bell was placed around the graphite rod cathode.

Following electrolysis, a Mo coating was formed on the inside of the fused quartz bell, on the side facing the cathode. The coating was analyzed by EDAX and confirmed as elemental molybdenum.

It is important to note that the fused quartz bell itself was not polarized and could not act as an electrode. The current efficiency was well below 100%. This indicates that non-Faradaic processes were occurring during the electrolysis, and that the Mo coating was produced by chemical, not electrochemical, processes.

Although this invention has been described with reference to its preferred embodiments, other variations and modifications will be apparent to those skilled in the art and it is intended to include all such variations and modifications within the scope of the appended claims. We Claim :

Claims

1. A method for producing a metal coating on a substrate (e.g.) an electrically conducting or insulating material) comprising :

a) selecting a first metal to be coated onto the substrate wherein said metal is soluble in a molten salt when heated to a first temperature,

b) heating a bath of said metal and molten salt to the first temperature to dissolve said metal,

c) placing the substrate to be coated in the bath, and

d) decreasing the temperature of the bath at the substrate to a second temperature, wherein the dissolved metal precipitates out of the molten salt onto the substrate at the second temperature.

2. The method of claim 1 further comprising selecting the metal and molten salt from the group consisting of Mn-MnCl$_2$/NaCl, Ag-AgCl/NaCl, Mo-K$_3$MoCl$_6$/KCl, Mg-MgCl$_2$, Ca-CaCl$_2$, Al-Na$_3$AlF$_6$, Na-NaCl, and Si-K$_2$SiF$_6$/KF.

3. The method of claim 1 further comprising enhancing precipitation of the dissolved metal out of the molten salt onto the substrate by adding more of said first metal to the bath, and optionally wherein additional metal is added to the bath by passage of an electric current through an electrode comprising said metal, the electrode being provided in the bath.

4. The method of claim 1 further comprising altering the salt composition after heating the first metal-molten salt solution to the first temperature.

5. The method of claim 4 further comprising cooling said first metal-molten salt solution to the second temperature, and optionally further comprising altering the salt composition to favor exsolution of said first dissolved metal.

6. The method of claim 1 further comprising selecting a second metal to be coated onto the substrate, wherein said first and second metals are soluble in a molten salt mixture.

7. The method of claim 1 for providing a multi-layered metal coating on a substrate, the metal comprising :

a) selecting a first metal to be coated onto the substrate wherein said first metal is soluble in a molten salt when heated to a first temperature,

b) heating a bath of said first metal and molten salt to the first temperature to dissolve said first metal,

c) placing the substrate to be coated in the bath,

d) decreasing the temperature of the bath at the substrate to a second temperature, wherein the dissolved first metal precipitates out of the molten salt onto the substrate at the second temperature,

e) selecting a second metal to be coated onto the substrate wherein said second metal is soluble in the molten salt when heated to a third temperature,

f) heating a bath of said second metal and molten salt to the third temperature to dissolve second metal,

g) placing the substrate to be coated in the bath, and,

h) decreasing the temperature of the bath at the substrate to a fourth temperature, wherein the dissolved second metal precipitates out of the molten salt onto the substrate at the fourth temperature, thereby providing a substrate having a multi-layered metal coating ; and optionally further comprising

i) changing the bath chemistries and processing parameters to create a multilayer coating of discrete compositions.

8. The method of claim 1 further comprising removing portions of said metal coating by heating said substrate in the metal-molten salt bath at the sites where the metal coating is to be removed, and optionally further wherein said substrate is heated using a laser to selectively redissolve portions of said metal coating.

9. The method of claim 1 further comprising masking areas of the substrate prior to precipitation of the metal onto the substrate.

10. The method of claim 1 for purifying a metal wherein the temperature of the bath is decreased to a temperature at which the pure metal precipitates out of the molten salt solution and the impurities remain in solution.

11. The method of claim 1 comprising the additional step of decreasing the temperature of the bath to a point at which the pure metal is in solution and the impurities precipitate out of the molten salt solution prior to precipitating the dissolved pure metal onto the substrate.

12. The method of claim 1 further comprising selecting a second metal, wherein said first and second metals are soluble in the molten salt when heated to a first temperature,

adding said second metal to the molten salt and

decreasing the temperature of the molten-salt bath to precipitate said first and second metals ; and optionally comprising adding said first metal to the molten salt bath at a ratio of said first metal to said second metal so said first and second metals co-precipitate.

13. The method of claim 1 further comprising adding impurities to the metal-molten salt bath, wherein said impurities precipitate out of solution with the metal.

14. The method of claim 1 further comprising maintaining a thermal gradient in the metal-molten salt bath, and optionally comprising continuously replenishing the metal-molten salt bath with dissolved metal.

15. The method of claim 14 further comprising continuously precipitating said metal onto substrate positioned appropriately within the thermal gradient.

16. A metal coating formed by :

a) selecting a first metal to be coated onto the substrate wherein said metal is soluble in a molten salt when heated to a first temperature,

b) heating a bath of said metal and said molten salt to the first temperature to dissolve said metal,

c) placing the substrate to be coated in the bath, and

d) decreasing the temperature of the bath at the substrate to a second temperature, wherein the dissolved metal precipitates out of the molten salt onto the substrate at the second temperature, the metal coating being optionally patterned by a subsequent patterning step which comprises heating said substrate in the metal-molten salt bath at the sites where the metal coating is to be removed.

17. A multilayer metal coating on a substrate formed by :

a) selecting a first metal to be coated onto the substrate wherein said first metal is soluble in a molten salt when heated to a first temperature,

b) heating a bath of said first metal and molten salt to the first temperature to dissolve said first metal,

c) placing the substrate to be coated in the bath,

d) decreasing the temperature of the bath at the substrate to a second temperature, wherein the dissolved first metal precipitates out of the molten salt onto the substrate at the second temperature,

e) selecting a second metal to be coated onto the substrate wherein said second metal is soluble in the molten salt when heated to a third temperature,

f) heating a bath of said second metal and molten salt to the third temperature to dissolve said second metal,

g) placing the substrate to be coated in the bath, and,

h) decreasing the temperature of the bath at the substrate to a fourth temperature, wherein the dissolved second metal precipitates out of the molten salt onto the substrate at the fourth temperature, thereby providing a substrate having a multilayered metal coating.

## Ansprüche

1. Verfahren zur Herstellung eines Metallüberzugs auf einem Grundmaterial (z.B. einem elektrisch leitenden oder Isoliermaterial), darin bestehend, daß

a) ein erstes, auf das Grundmaterial aufzubringendes Metall ausgewählt wird, wobei das Metall in einem geschmolzenen Salz löslich ist, wenn es auf eine erste Temperatur erwärmt wird,

b) ein Bad des Metalls und geschmolzenen Salzes auf die erste Temperatur zum Auflösen des Metalls erwärmt wird,

c) das zu überziehende Grundmaterial in das Bad eingegeben wird und

d) die Temperatur des Bades am Grundmaterial auf eine zweite Temperatur herabgesetzt wird, wobei sich das gelöste Metall aus dem geschmolzenen Salz auf das Grundmaterial bei der zweiten Temperatur abscheidet.

2. Verfahren nach Anspruch 1, ferner darin bestehend, daß das Metall und geschmolzene Salz aus der aus Mn-MnCl$_2$/NaCl, Ag-AgCl/NaCl, Mo-K$_3$MoCl$_6$/KCl, Mg-MgCl$_2$, Ca-CaCl$_2$, Al-Na$_3$AlF$_6$, Na-NaCl und Si-K$_2$SiF$_6$/KF bestehenden Gruppe ausgewählt wird.

3. Verfahren nach Anspruch 1, ferner darin bestehend, daß die Abscheidung des gelösten Metalls aus dem geschmolzenen Salz auf das Grundmaterial dadurch verstärkt wird, daß dem Bad mehr von dem ersten Metall zugegeben wird, indem ggf. dem Bad zusätzliches Metall durch Durchleiten eines elektrischen Stroms duch eine das Metall umfassende Elektrode zugegeben wird, wobei die Elektrode im Bad vorgesehen ist.

4. Verfahren nach Anspruch 1, ferner darin bestehend, daß die Salzzusammensetzung nach dem Erwärmen der Lösung des ersten Metalls und geschmolzenen Salzes auf die erste Temperatur geändert wird.

5. Verfahren nach Anspruch 4, ferner darin bestehend, daß die Lösung des ersten Metalls und geschmolzenen Salzes auf die zweite Temperatur gekühlt wird und ggf. ferner die Salzzusammensetzung zur Begünstigung des Außerlösunggehens des ersten gelösten Metalls geändert wird.

6. Verfahren nach Anspruch 1, ferner darin bestehend, daß ein zweites, auf das Grundmaterial aufzubringendes Metall ausgewählt wird, wobei das erste und das zweite Metall in einem geschmolzenen Salzgemisch löslich sind.

7. Verfahren nach Anspruch 1 zur Bildung eines mehrschichtigen Metallüberzugs auf einem Grundmaterial, darin bestehend, daß

a) ein erstes, auf das Grundmaterial aufzubringendes Metall ausgewählt wird, wobei das erste Metall in einem geschmolzenen Salz lösbar ist, wenn es auf eine erste Temperatur erwärmt wird,

b) ein Bad des ersten Metalls und geschmolzenen Salzes auf die erste Temperatur zum Lösen des ersten Metalls erwärmt wird,

c) das zu überziehende Grundmaterial in das Bad eingegeben wird,

d) die Temperatur des Bades am Grundmaterial auf eine zweite Temperatur herabgesetzt wird, wobei sich das gelöste erste Metall aus dem geschmolzenen Salz auf das Grundmaterial bei der zweiten Temperatur abscheidet,

e) ein zweites, auf das Grundmaterial aufzubringendes Metall ausgewählt wird, wobei das zweite Metall in dem geschmolzenen Salz lösbar ist, wenn es auf eine dritte Temperatur erwärmt wird,

f) ein Bad des zweiten Metalls und geschmolzenen Salzes auf die dritte Temperatur zum Lösen des zweiten Metalls erwärmt wird,

g) das zu überziehende Grundmaterial in das Bad eingegeben wird und

h) die Temperatur des Bades am Grundmaterial auf eine vierte Temperatur herabgesetzt wird, wobei sich das gelöste zweite Metall aus dem geschmolzenen Salz auf das Grundmaterial bei der vierten Temperatur abscheidet, wodurch ein Grundmaterial mit einem mehrschichtigen Metallüberzug gebildet wird, und ggf. ferner

i) die chemischen Eigenschaften des Bades und Behandlungsparameter zur Erzeugung eines Mehrschichtüberzugs von einzelnen Zusammensetzungen geändert werden.

8. Verfahren nach Anspruch 1, ferner darin bestehend, daß Bereiche des Metallüberzugs dadurch entfernt werden, daß das Grundmaterial in dem Bad aus Metall und geschmolzenem Salz an den Stellen erwärmt wird, an denen der Metallüberzug zu entfernen ist, und ggf. ferner das Grundmaterial unter Verwendung eines Lasers zur selektiven Wiederauflösung von Bereichen des Metallüberzugs erwärmt wird.

9. Verfahren nach Anspruch 1, ferner darin bestehend, daß Zonen des Grundmaterials vor der Abscheidung des Metalls auf das Grundmaterial maskiert werden.

10. Verfahren nach Anspruch 1 zum Reinigen eines Metalls, bei dem die Temperatur des Bades auf eine Temperatur herabgesetzt wird, bei der sich das reine Metall aus der Lösung des geschmolzenen Salzes abscheidet und die Verunreinigungen in Lösung bleiben.

11. Verfahren nach Anspruch 1, mit dem zusätzlichen Schritt, daß die Temperatur des Bades auf einen Punkt herabgesetzt wird, bei dem das reine Metall in Lösung ist und sich die Verunreinigungen aus der Lösung des geschmolzenen Salzes vor dem Abscheiden des gelösten reinen Metalls auf das Grundmaterial abscheiden.

12. Verfahren nach Anspruch 1, ferner darin bestehend, daß ein zweites Metall ausgewählt wird, wobei das erste und das zweite Metall in dem geschmolzenen Salz bei Erwärmung auf eine erste Temperatur lösbar sind, das zweite Metall dem geschmolzenen Salz zugegeben wird und die Temperatur des Bades geschmolzenen Salzes für eine Abscheidung des ersten und des zweiten Metalls verringert wird und ggf. das erste Metall dem Bad geschmolzenen Salzes in einem solchen Verhältnis des ersten Metalls zum zweiten Metall zugegeben wird, daß sich das erste und das zweite Metall miteinander abscheiden.

13. Verfahren nach Anspruch 1, ferner darin bestehend, daß Verunreinigungen dem Bad des Metalls und geschmolzenen Salzes zugegeben werden, wobei sich die Verunreinigungen mit dem Metall aus der Lösung abscheiden.

14. Verfahren nach Anspruch 1, ferner darin bestehend, daß ein Wärmegradient in dem Bad des Metalls und geschmolzenen Salzes aufrechterhalten wird und ggf. das Bad des Metalls und geschmolzenen Salzes kontinuierlich mit gelöstem Metall wieder aufgefüllt wird.

15. Verfahren nach Anspruch 14, ferner darin bestehend, daß das Metall kontinuierlich auf entsprechend innerhalb des Wärmegradienten positioniertes Grundmaterial abgeschieden wird.

16. Metallüberzug, gebildet durch

a) Auswählen eines ersten, auf das Grundmaterial aufzubringenden Metalls, wobei das Metall in einem geschmolzenen Salz lösbar ist, wenn es auf eine erste Temperatur erwärmt wird,

b) Erwärmen eines Bades des Metalls und des geschmolzenen Salzes auf die erste Temperatur zum Lösen des Metalls,

c) Einbringen des zu überziehenden Grundmaterials in das Bad und

d) Verringerung der Temperatur des Bades am Grundmaterial auf eine zweite Temperatur, wobei sich das gelöste Metall aus dem geschmolzenen Salz auf das Grundmaterial bei der zweiten Temperatur abscheidet und der Metallüberzug ggf. durch einen nachfolgenden Mustergebungsschritt, der darin besteht, daß das Grundmaterial in dem Bad des Metalls und geschmolzenen Salzes an den Stellen erwärmt wird, an denen der Metallüberzug entfernt werden soll, ein Muster erhält.

17. Mehrschichtmetallüberzug auf einem Grundmaterial, gebildet durch

a) Auswählen eines ersten, auf das Grundmaterial aufzubringenden Metalls, bei dem das erste Metall in einem geschmolzenen Salz lösbar ist, wenn es auf eine erste Temperatur erwärmt wird,

b) Erwärmen eines Bades des ersten Metalls und geschmolzenen Salzes auf die erste Temperatur zum Auflösen des ersten Metalls,

c) Einbringen des zu überziehenden Grundmaterials in das Bad,

d) Verringern der Temperatur des Bades am Grundmaterial auf eine zweite Temperatur, wobei sich das gelöste erste Metall aus dem geschmolzenen Salz auf das Grundmaterial bei der zweiten Temperatur abscheidet,

e) Auswählen eines zweiten, auf das Grundmaterial aufzubringenden Metalls, wobei das zweite Metall in dem geschmolzenen Salz lösbar ist, wenn es auf eine dritte Temperatur erwärmt wird,

f) Erwärmen eines Bades des zweiten Metalls und geschmolzenen Salzes auf die dritte Temperatur zum Lösen des zweiten Metalls,

g) Einbringen des zu überziehenden Grundmaterials in das Bad und

h) Verringerung der Temperatur des Bades am Grundmaterial auf eine vierte Temperatur, wobei sich das gelöste zweite Metall aus dem geschmolzenen Salz auf das Grundmaterial bei der vierten Temperatur abscheidet, wodurch ein Grundmaterial mit einem mehrschichtigen Metallüberzug gebildet wird.


## Revendications

1. Procédé pour l'obtention d'un revêtement métallique sur un substrat (par exemple, une matière électriquement conductrice ou isolante), ce procédé consistant à :

a) sélectionner un premier métal destiné à recouvrir le substrat, le métal étant soluble dans un sel fondu lorsqu'on le chauffe à une première température ;

b) chauffer à la première température, un bain constitué de ce métal et de ce sel fondu, afin de dissoudre le métal ;

c) placer dans le bain le substrat à recouvrir, et

d) diminuer la température du bain au substrat à une deuxième température, le métal dissous précipitant hors du sel fondu sur le substrat à la deuxième température.

2. Procédé selon la revendication 1, consistant, en outre, à sélectionner le métal et le sel fondu à partir du groupe comprenant Mn-MnCl$_2$/NaCl, Ag-AgCl/NaCl, Mo-K$_3$MoCl$_6$/KCl, Mg-MgCl$_2$, Ca-CaCl$_2$, Al-Na$_3$AlF$_6$, Na-NaCl et Si-K$_2$SiF$_6$/KF.

3. Procédé selon la revendication 1, consistant, en outre, à accentuer la précipitation du métal dissous hors du sel fondu sur le substrat en ajoutant une quantité supplémentaire du premier métal au bain, et éventuellement dans lequel on ajoute la quantité supplémentaire de métal au bain en faisant passer un courant électrique à travers une électrode constituée de ce métal, l'électrode étant prévue dans le bain.

4. Procédé selon la revendication 1, consistant, en outre, à modifier la composition de sel après avoir chauffé la première solution de métal-sel fondu à la première température.

5. Procédé selon la revendication 4, consistant, en outre, à refroidir cette première solution de métal-sel fondu à la deuxième température et consistant éventuellement, en outre, à modifier la composition du sel pour favoriser le fait que le premier métal dissous quitte la solution.

6. Procédé selon la revendication 1, consistant, en outre, à sélectionner un second métal destiné à recouvrir le substrat, les premier et second métaux étant solubles dans un mélange de sels fondus.

7. Procédé selon la revendication 1, destiné à fournir un revêtement métallique multicouche sur un substrat, ce procédé consistant à :

a) sélectionner un premier métal destiné à recouvrir le substrat, le premier métal étant soluble dans un sel fondu lorsqu'on le chauffe à une première température ;

b) chauffer à la première température un bain constitué du premier métal et du sel fondu afin de dissoudre le premier métal ;

c) placer dans le bain le substrat à recouvrir ;

d) diminuer la température du bain au substrat à une deuxième température, le premier métal dissous précipitant hors du sel fondu sur le substrat à la deuxième température ;

e) sélectionner un second métal destiné à recouvrir le substrat, le second métal étant soluble dans le sel fondu lorsqu'on le chauffe à une troisième température ;

f) chauffer à la troisième température un bain constitué du second métal et du sel fondu afin de dissoudre le second métal ;

g) placer dans le bain le substrat à recouvrir ; et

h) diminuer la température du bain au substrat a une quatrième température, le second métal dissous précipitant hors du sel fondu sur le substrat à la quatrième température, fournissant ainsi un substrat muni d'un revêtement métallique multicouche ; et consistant éventuellement, en outre, à

i) modifier les données chimiques du bain et les paramètres de traitement afin de créer un revêtement multicouche de compositions discrètes.

8. Procédé selon la revendication 1, consistant, en outre, à éliminer des portions du revêtement métallique en chauffant le substrat dans le bain de métal-sel fondu aux sites où le revêtement métallique doit être éliminé, et éventuellement consistant, en outre, à chauffer le substrat en faisant appel à un laser afin de redissoudre sélectivement les portions du revêtement métallique.

9. Procédé selon la revendication 1, consistant, en outre, à masquer des zones du substrat avant que le métal ne se précipite sur le substrat.

10. Procédé selon la revendication 1, destiné à purifier un métal, dans lequel on diminue la température du bain à une température à laquelle le métal pur précipite hors de la solution de sel fondu, les impuretés demeurant en solution.

11. Procédé selon la revendication 1, comprenant l'étape supplémentaire consistant à diminuer la température du bain à un point auquel le métal pur se trouve en solution et les impuretés précipitent hors de la solution de sel fondu, avant que le métal pur dissous ne se précipite sur le substrat.

12. Procédé selon la revendication 1, consistant, en outre, à sélectionner un second métal, dans lequel les premier et second métaux sont solubles dans le sel fondu lorsqu'il est chauffé à une première température,

ajouter le second métal au sel fondu et

diminuer la température du bain de sel fondu afin de précipiter les premier et second métaux ; et consistant éventuellement à ajouter le premier métal au bain de sel fondu, selon un rapport premier métal/second métal, tel que les premier et second métaux coprécipitent.

13. Procédé selon la revendication 1, consistant, en outre, à ajouter des impuretés au bain de métal-sel fondu, ces impuretés précipitant hors de la solution, avec le métal.

14. Procédé selon la revendication 1, consistant, en outre, à maintenir un gradient thermique au sein du bain de métal-sel fondu et éventuellement consistant à réapprovisionner en continu le bain de métal-sel fondu avec du métal dissous.

15. Procédé selon la revendication 14, consistant, en outre, à précipiter en continu le métal sur le substrat positionné de manière appropriée, au sein du gradient thermique.

16. Revêtement métallique obtenu par le fait de :
a) sélectionner un premier métal destiné recouvrir le substrat, le métal étant soluble dans un sel fondu lorsqu'on le chauffe à une première température ;
b) chauffer à la première température un bain constitué du métal et du sel fondu afin de dissoudre le métal ;
c) placer dans le bain le substrat à recouvrir ; et
d) diminuer la température du bain au substrat à une deuxième température, le métal dissous précipitant hors du sel fondu sur le substrat à la deuxième température, le revêtement métallique étant éventuellement modelé par l'intermédiaire d'un étape ultérieure de modelage qui consiste à chauffer le substrat dans le bain de métal-sel fondu aux sites où le revêtement métallique doit être éliminé.

17. Revêtement métallique multicouche sur un substrat obtenu par le fait de :
a) sélectionner un premier métal destiné à recouvrir le substrat, le premier métal étant soluble dans un sel fondu lorsqu'on le chauffe à une première température ;
b) chauffer à la première température un bain constitué du premier métal et du sel fondu afin de dissoudre le premier métal ;
c) placer dans le bain le substrat à recouvrir ;
d) diminuer la température du bain au substrat à une deuxième température, le premier métal dissous précipitant hors du sel fondu sur le substrat à la deuxième température ;
e) sélectionner un second métal destiné à recouvrir le substrat, le second métal étant soluble dans le sel fondu lorsqu'on le chauffe à une troisième température ;
f) chauffer à la troisième température un bain constitué du second métal et du sel fondu afin de dissoudre le second métal ;
g) placer dans le bain le substrat a recouvrir ; et
h) diminuer la température du bain au substrat à une quatrième température, le second métal dissous précipitant hors du sel fondu sur le substrat à la quatrième température, fournissant ainsi un substrat muni d'un revêtement métallique multicouche.